# EUROPEAN PATENT SPECIFICATION

(11) **EP 0 550 435 B1**
(45) Date of publication and mention of the grant of the patent: **18.09.1996**
(21) Application number: 90916897.3
(22) Date of filing: 13.11.1990
(51) Int. Cl.: H01L 41/08

(54) **PIEZOELECTRIC SOLID STATE MOTOR STACK**
PIEZOELEKTRISCHER SCHICHTACHTIGER FESTKÖRPERMOTOR
BLOC DE MOTEUR MONOLITHE PIEZOELECTRIQUE

(30) Priority: 28.09.1990 US 589855
(43) Date of publication of application: 14.07.1993
(73) Proprietor: CATERPILLAR INC., Peoria Illinois 61629-6490 (US)
(72) Inventor: DAM, Chuong, Q., Peoria, IL 61615 (US); HESTER, Virgil, R. Rural Route 3, Delavan, IL 61734 (US); KELLEY, Kurtis, C., Washington, IL 61571 (US); TOWE, Carey, A., South Carolina 29841 (US)
(74) Representative: Wagner, Karl H., Dipl.-Ing.
(86) International application number: US9006535
(87) International publication number: WO9206511

(56) References cited:
- EP-A- 0 144 655
- US-A- 3 501 099

## Description

### 1. Field of the Invention

The field of the invention relates generally to solid state motor actuators. More particularly, the invention relates to a piezoelectric solid state motor stack structure.

### 2. Related Art

For decades electroexpansive materials have been employed in stacked structures for producing actuation used for fuel injection and valve control in diesel engines, for example. Commercially manufactured solid state motor stacks, or actuators, are produced using piezoelectric disks interleaved with metal foil electrodes. Application of high voltage (e.g., 1000V DC), low current power to alternately biased electrodes causes each of the piezoelectric disks to expand or axially distort. The additive deflection of the stacked disks is typically amplified by hydraulics to effectuate useful actuation.

An example of a conventional electromechanical actuator having an active element of electroexpansive material is found in United States Patent No. 3,501,099 to Glendon M. Benson. Benson's 1970 patent is directed to both an actuation amplification structure and a method for manufacturing piezoelectric stacks. Sheets of ceramic material are rolled, compacted and punched into ceramic disks. After a cleaning process, the disks are stacked with alternate sets of continuous disk electrodes disposed between the ceramic disks. The stacks undergo a pressurized cool-welding process, followed by an elevated temperature and pressure bonding process after common electrodes are connected to the two electrode groups. The stacks are poled by application of a DC voltage and then encapsulated with a plastic insulative cover prior to final mounting within a transducer housing.

An example of a conventional low voltage multilayer piezoelectric ceramic actuator with varying thickness layers is taught by Takahashi et al. See Meeting on Ferroelectric Materials and Their Applications (5th), 1985. p. 206-208. Takahashi et al. have developed a multilayer ceramic actuator used for impact matrix printer heads with an applied electric voltage of lower than 100V. Due to the low driving voltages, the Takahashi et al. multilayer actuators do not produce forces of large magnitude, and thus, the ceramic disks are prone to less failures. Takahashi have studied such actuators using finite element method analysis in an attempt to reduce stresses induced at an adhesive layer between the ceramic actuator and a mass load to which the body is attached.

The structure taught by Takahashi et al. includes two different thickness active layers and an inactive, non-stressing, layer disposed at one end of the multilayer actuator. The mass load and ceramic layers have rectangular surface areas. A surface of the mass load is attached to a surface of an inactive layer by an adhesive. Adjacent the other surface of the inactive layer is a first active layer with a first thickness. Stacked under the first active layer is a number of second active layers of a second thickness, the second thickness being smaller than the first thickness. Two sets of electrodes are alternately interleaved with the active layers for application of the driving voltage.

The article reports that no mechanical rupture of the adhesive layer occurs as a result of such a structure. This result is further attributed to an edge hook on the mass load that overlaps down along a side edge of the inactive layer.

An example of another conventional electromechanical actuator having an active element of electroexpansive material is found in EP Patent Application 0 144 655. This actuator design discloses a stack of multiple electrostriction layers wherein the layers have axially varied thickness.

In accordance with the present invention a piezoelectric solid state motor stack as set forth in claim 1 is provided. A preferred embodiment of the invention is disclosed in claim 2.

The present invention overcomes the deficiencies of the conventional technology noted above.

### SUMMARY OF THE INVENTION

The present invention is directed to a piezoelectric solid state motor stack having a plurality of piezoelectric disks interleaved with a plurality of electrodes, with at least one first piezoelectric disk of a first thickness sandwiched between at least two second piezoelectric disks of a second thickness, the second thickness being different from the first thickness. At least two electrodes are interleaved with at least two of the plurality of disks such that each electrode is in contact with a surface of at least one of the plurality of disks. The sandwiched disks have surface facets covered with a conductive layer. When the electrodes are connected to and biased by a source of electrical potential, an axial displacement is produced between opposite end surfaces of the stack.

The invention may further include at least two disks of a third thickness, different from the first and second thicknesses, sandwiching between them the combination of the disks of the first and second thicknesses. Moreover, electrodes may be interleaved with the disks of the third thickness and the disks of the second thickness.

The invention may still further include at least two disks of a fourth thickness, different from the first through third thicknesses, sandwiching between them the combination of the disks of the first through third thicknesses. Still further electrodes are interleaved with the disks of the fourth thickness and the disks of the third thickness.

### BRIEF DESCRIPTION OF THE DRAWINGS

The invention will be better understood if reference is made to the accompanying drawings in which:
**FIG. 1** is a cross-sectional view of a housed piezoelectric stack in connection with the present invention;
**FIG. 2** is an expanded view of a piezoelectric stack in connection with the present invention; and
**FIG. 3** is a sectional view of the disk/electrode stack of FIG. 2 with electrode tabs connected to respective busses and lead wires.

### DETAILED DESCRIPTION OF THE PREFERRED EMBODIMENTS

Piezoelectric solid state motor stacks according to the present invention are high-force devices that have minimized stack failure due to disk breakage caused by stress. Piezoelectric solid state motor stacks according to the present invention can be used to improve engine performance, reduce emissions, and reduce engine noise. The utility of the present invention is not, however, limited to engine valve and fuel injector actuation. The invention may be used in brake or shock absorbing systems, for example. Moreover, the invention may be used in a wide variety of devices or systems requiring fluid or mechanical actuation, as well as shock or sound wave production. A particular advantage of the solid state motor stack of this invention is its ability to operate over a wide temperature range. Tests on prototype motor stacks have shown good results in operating environments of -40°C to 100°C.

It should be understood that the present invention is directed to a piezoelectric solid state motor stack structure. However, the terms solid state motor stack and electroexpansive actuator, for example, are synonymous. Throughout this discussion, the piezoelectric solid state motor stacks will be commonly referred to as "stacks."

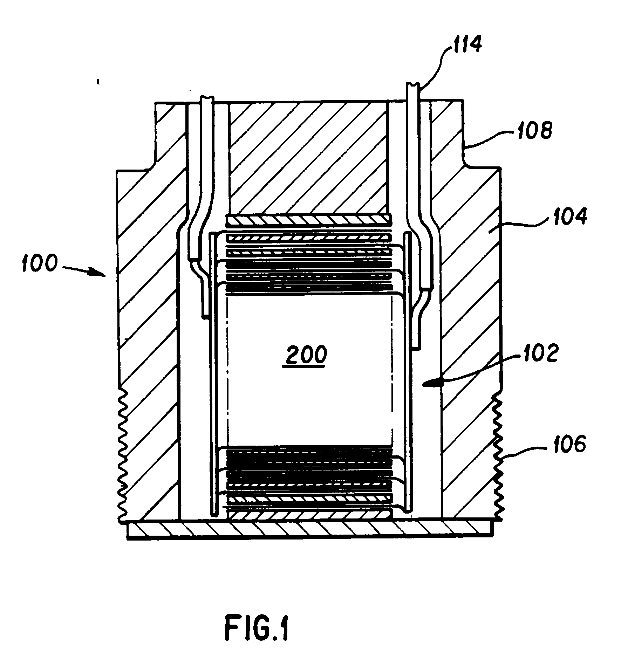

FIG. 1 shows the piezoelectric solid state stack motor **102** of the present invention in a housing **104**. The preferred embodiment for the housing and encapsulation of the present piezoelectric solid state stack motor invention is shown in the concurrently filed, commonly assigned co-pending application Serial No. (Attorney Docket No. 1246.0120000/90-215), titled "Coating Surrounding A Piezoelectric Solid State Motor Stack", the disclosure of which is incorporated herein by reference. The housing is a steel case and is cylindrical in shape with a hollow cylindrical cavity for housing the solid state stack. Threads **106** attach the piezoelectric solid state motor housing to an engine head. Plateau **108** represents a hexagonal cross section, if viewed from the top of FIG. 1. This hexagonal structure is not shown in the figure, but is used for tightening and loosening of the piezoelectric solid state motor housing on the engine head. Throughports are bored in the top end of the housing to permit bus lead wires **114** to exit the housing.

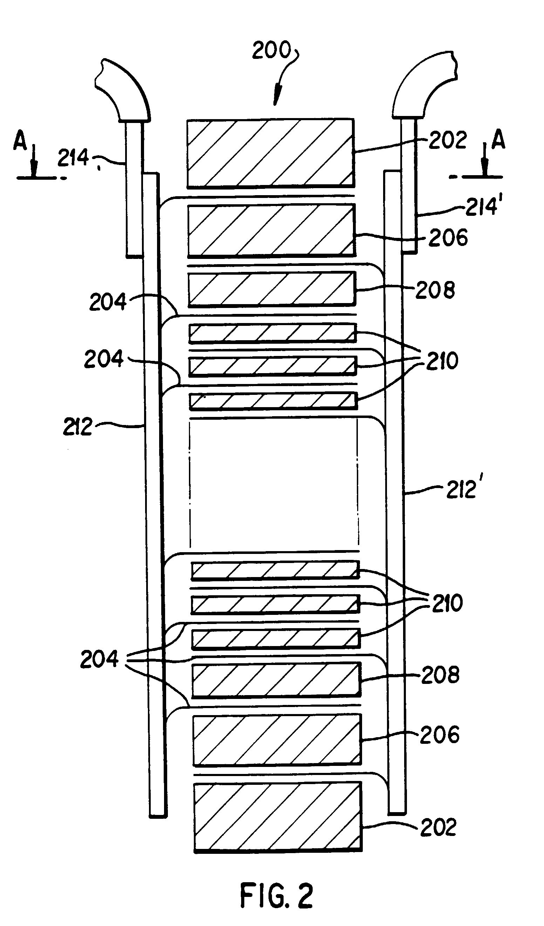

FIG. 2 is an expanded diagram of the disks forming the stack structure **200**. Ceramic disks suitable for use in making a motor stack are commercially available. The piezoelectric solid state motor stack is bounded by non-polarized ceramic end caps **202**. The stack also includes thick ceramic disks **206**, medium thick ceramic disks **208**, inner thin ceramic disks **210**, bus bars **212, 212'**, and lead wires **214, 214'**.

Each facet surface of the thick, medium thick and thin disks is coated with a conductive coating, preferably aluminum. The application of the conductive layer may be accomplished by various methods as would become evident to those of skill in the art. The conductive layer is preferably applied to all of the surface area of the upper and lower facets of the disks. Uniformity of the conductive layer is desired. However, uniformity and full facet surface coverage may be limited by the method used to apply the conductive layer.

The conductive layer may be applied by sputtering, spraying or mechanically rubbing atomic layers of the conductive material onto the facet surfaces of the disks. Chemical vapor deposition may also be used to apply the conductive layer. The conductive layer may also comprise copper, nickel or silver. The conductive layer functions to more evenly spread the electric field across the surface of the disk when a voltage is applied to an adjacent electrode in the final stack structure.

The inner thin disks **210** are sandwiched by the medium thick disks **208**. In a preferred embodiment, approximately 71 thin disks are used. The combination of the thin and medium thick disks are in turn sandwiched by the thick disks **206**, and the combination of the thin, medium thick and thick disks are sandwiched by the end caps **202**.

The thick, medium thick and thin disks have thicknesses of approximately 1.016, 0.762 and 0.508 mm, respectively. The thickness of the end caps is preferably 2.500 mm. Each of the first through fourth disk thicknesses has a tolerance of about ± 0.013 mm.

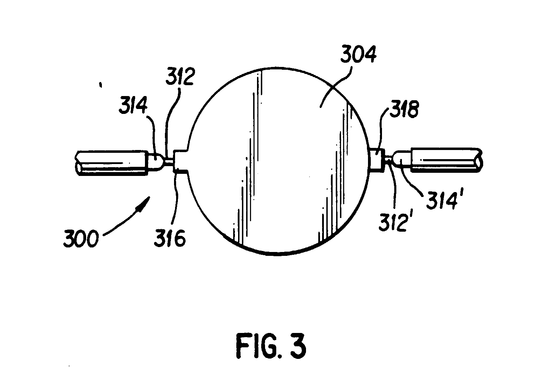

FIG. 3 is a sectional view through line A-A in FIG. 2 showing the electrode assembly **300**. A top electrode **304** has a tab **316** electrically connected to a bus bar (wire) **312**, for example, by soldering or laser welding. A lead wire **314** is then electrically connected (again, by soldering or laser welding, for example) to the bus bar **312**. A next adjacent electrode (not shown) has a tab **318** offset from tab **316** (by about 180° in the example shown). Tab 318 is electrically connected to a second bus bar **312'**. The bus bar **312'** in turn is electrically connected to a second lead wire **314'**.

Assembly of the above structure will now be discussed. Preferably, an assembly fixture comprising a half-cylindrical tube with a metal plug located at the bottom, assembly begins by inserting a first end-cap ceramic disk into the assembly fixture. (Note that the facet surfaces of the end caps are not coated with a conductive layer.) A first electrode is aligned in the assembly fixture on top of the first end cap ceramic disk. The tab of the first electrode is given a first orientation. The stacking of a thick disk is next, followed by another electrode. This next electrode is stacked on top of the thick disk and its tab is given a second orientation. In the presently preferred embodiment shown, the second orientation is 180° from the first orientation. The orientation, or circumferential displacement between successive electrode tabs, may vary as long as the respective orientations are maintained for alternating electrodes during the stacking process. It is only necessary that the electrode tabs and bus bars be spaced apart sufficiently to prevent arc over between 'bus bars and to prevent localized disk heating generated by the applied electric fields.

A medium thick disk is stacked on the second electrode. A third electrode is stacked on top of the medium thick disk. The tab of the third electrode is oriented oppositely to that of the second stacked electrode and thus similarly to that of the first electrode. A first thin disk is then stacked in the assembly fixture. A fourth electrode, again with an opposite orientation to the third stacked electrode, is then placed on the first thin disk. Successive thin disks are stacked with interleaved electrodes, such that every successive electrode is oriented oppositely to the immediately preceding electrode. When the last thin disk has been stacked, another medium thick disk, thick disk, and end cap are stacked with electrodes interleaved therebetween. Finally, a second end cap is stacked on top of the last electrode. The ceramic end caps **202** are not sandwiched by electrodes **204**.

Once assembled, the disk/electrode stack comprises two longitudinal rows of disk tabs offset from each other by up to 180°. In one embodiment, each tab of each row of tabs is bent and presoldered to facilitate connection to a bus bar. Each of the tabs is slotted so that the bus bar may be positioned in the slots. The tab length, as measured parallel to a line tangent to the circumference of the electrode, should be sufficient to permit free expansion and contraction of the stack during operation.

Other bus bar-electrode combinations are contemplated. These are described in concurrently filed, commonly assigned co-pending applications, Serial No. (Attorney. Docket No. 1246.0090000/90-217), titled "Slotted Bus Bar For A Piezoelectric Solid State Motor", and Serial No. (Attorney Docket No. 1246.0070000/88-298), titled "Single-Piece Multiple Electrode Conductor", the disclosures of which are incorporated herein by reference.

In the presently preferred embodiment, the electrode bus bar connection is accomplished as follows. Solder is applied to each of the tabs via a hand soldering gun, for example. The tabs may also be dipped in a solder bath. Two 22-gauge tin-copper wire bus bars are appropriately positioned along respective presoldered bent tab rows. The bus wires may be cleaned with isopropyl alcohol and treated with a liquid solder flux. Once positioned, the bus wires are soldered to the respective electrode tabs to form a bus structure.

The final housing assembly will now be discussed. Poling, or alignment of the thick, medium thick, and thin ceramic disks' dipoles is necessary to achieve axial expansion of the piezoelectric ceramic disks upon the application of an electrical potential to the stack. This is preferably done once the stack is assembled in accordance with guidelines provided by the ceramic manufacturer. In the presently preferred embodiment, poling of the stack is accomplished at an elevated temperature (about 145°C). A poling voltage signal is applied to the stack in three stages. During the first stage a 0-volt to 1200-volt charge is applied linearly during a two-minute interval. For the second stage the voltage is held at 1200-volts for 10 minutes. Finally, the voltage is linearly reduced to 0-volts during a five-minute period. The stack is then cooled to room temperature. The ceramic end caps are not polarized during the poling process because they are not sandwiched by electrodes.

The bus bars **212, 212'** are soldered to the lead wires **214, 214**, respectively, and a layer of shrink-wrap tubing is applied to the lead wires as an insulator.

## Claims

1. A piezoelectric solid state motor stack (200) having a plurality of piezoelectric disks interleaved with a plurality of electrodes, characterized in that:
a plurality of inner piezoelectric disks (210) of a first thickness being aligned in a column;
first and second medium piezoelectric disks (208) of a second thickness sandwiching the column of inner piezoelectric disks, the first thickness of said inner disks being smaller than the second thickness of said second disks;
first and second thick piezoelectric disks (206) of a third thickness sandwiching the combination of said inner and medium disks, the second thickness of said medium disks being smaller than the third thickness of said third disks, said inner, medium and thick disks having opposing surface facets;
a conductive layer covering the surface facets of said inner, medium and thick disks (210,208,206) wherein each of the conductive layers functions to evenly spread an electric field across the surface facets and
a plurality of electrodes (204) each comprising a tab (316) formed integrally therewith and extending outwardly from the periphery of the electrode, said electrodes being interleaved with and sandwiched between the facing surfaces of said inner, medium and large disks (210,208,206), such that said electrodes (204) are in contact with the conductive layers, and the tabs thereof comprise two rows offset from each other;
first and second non-polarized ceramic end caps (202) of a fourth thickness sandwiching the combination of said electrodes, inner, medium and thick disks (210,208,206,204), the third thickness of said thick disks being smaller than the fourth thickness of said end caps;
whereby the electrode tabs are connected to and biased by a source of electrical potential, such that an axial displacement is produced, between opposite end surfaces of the stack (200).

2. A piezoelectric solid state motor stack (200) according to claim 1, wherein the stack further comprises:
first means (212) for electrically connecting together said first longitudinal arrangement of tabs (316); and
second means (212') for electrically connecting together said second longitudinal arrangement of tabs (318);
to thereby bias said electrodes (204) when a source of electrical potential is connected to said first and second electrical connection means (212,212').

## Patentansprüche

1. Ein piezoelektrischer Festkörpermotorstapel (200) mit einer Vielzahl von piezoelektrischen Scheiben die mit einer Vielzahl von Elektroden ineinandergreifend angeordnet sind,
dadurch gekennzeichnet daß:
eine Vielzahl von inneren piezoelektrischen Scheiben (210) einer ersten Dicke in einer Säule ausgerichtet ist;
erste und zweite mittlere piezoelektrische Scheiben (208) einer zweiten Dicke sandwichartig angeordnet mit der Säule aus inneren piezoelektrischen Scheiben wobei die erste Dicke der erwähnten inneren Scheiben kleiner ist als die zweite Dicke der zweiten Scheiben;
erste und zweite dicke piezoelektrische Scheiben (206) einer dritten Dicke die die Kombination der inneren und mittleren Scheiben sandwichartig anordnen, wobei die zweite Dicke der mittleren Scheiben kleiner ist als die dritte Dicke der dritten Scheiben, und wobei die inneren, mittleren und dicken Scheiben entgegengesetztliegende Oberflächenfacetten aufweisen;
eine leitende Schicht welche die Oberflächenfacetten der inneren, mittleren und dicken Scheiben (210,208,206) abdecken, wobei jede der leitenden Schichten dazu dient ein elektrisches Feld über die Oberflächenfacetten gleichmäßig zu verteilen;
eine Vielzahl von Elektroden (204) deren jede einen Ansatz (316) integral damit ausgebildet aufweist und zwar sich vom Umfang der Elektrode nach außen erstreckend, wobei die Elektroden ineinandergreifend mit und sandwichartig zwischen den aufeinanderzuweisenden Oberflächen der inneren, mittleren und großen Scheiben (210,208,206) derart angeordnet sind, daß die Elektroden (204) in Kontakt mit den leitenden Schichten stehen wobei die Ansätze davon zwei Reihen versetzt voneinander besitzen; erste und zweite nicht polarisierte keramische Endkappen (202) einer vierten Dicke, welche die Kombination der Elektroden, der inneren, mittleren und dicken Scheiben (210,208,206,204) sandwichartig anordnen, wobei die dritte Dicke der dicken Scheiben kleiner ist als die vierte Dicke der Endkappen; und
wobei die Elektrodenansätze mit einer elektrischen Potentialquelle verbunden und durch diese vorgespannt sind, derart, daß eine axiale Verschiebung oder Versetzung zwischen entgegengesetzt liegenden Endoberflächen des Stapels (200) erzeugt wird.

2. Piezoelektrischer Festkörpermotorstapel (200) nach Anspruch 1 wobei der Stapel ferner folgendes aufweist:
erste Mittel (212) zum elektrischen Verbinden der ersten Längsanordnung von Ansätzen (316) miteinander; und
zweite Mittel (212') zum elektrischen Verbinden der zweiten Längsanordnung von Ansätzen (318) miteinander;
wobei dadurch die Elektroden (204) vorgespannt werden, wenn eine Potentialquelle mit den ersten und zweiten elektrischen Verbindungsmitteln (212,212') verbunden ist.

## Revendications

1. Empilement moteur piézo-électrique (200) comprenant une pluralité de disques piézo-électriques intercalés avec une pluralité d'électrodes, caractérisé par :
une pluralité de disques piézo-électriques internes (210) d'une première épaisseur alignés en une colonne ;
des premier et second disques piézo-électriques médians (208) d'une seconde épaisseur prenant en sandwich la colonne de disques piézo-électriques internes, la première épaisseur des disques internes étant inférieure à la seconde épaisseur des seconds disques ;
des premier et second disques piézo-électriques épais (206) d'une troisième épaisseur prenant en sandwich la combinaison des disques internes et médians, la seconde épaisseur des disques médians étant inférieure à la troisième épaisseur des troisièmes disques, les disques internes, médians et épais ayant des faces opposées ;
une couche conductrice recouvrant les faces des disques internes, médians et épais (210, 208, 206), chacune des couches conductrices agissant pour répartir de façon régulière le champ électrique sur les faces ; et
chacune d'une pluralité d'électrodes (204) comprenant une patte (316) formée d'une seule pièce avec celle-ci s'étendant vers l'extérieur par rapport à la périphérie de l'électrode, les électrodes étant intercalées et prises en sandwich entre les faces en vis-à-vis des disques internes, médians et épais (210, 208, 206), de sorte que lesdites électrodes (204) sont en contact avec des couches conductrices et que leurs pattes constituent deux rangées décalées l'une par rapport à l'autre ;
des premier et second capuchons d'extrémité en céramique non-polarisés (202) d'une quatrième épaisseur prenant en sandwich la combinaison des électrodes, et des disques internes, médians et épais (210, 208, 206, 204), la troisième épaisseur des disques épais étant inférieure à la quatrième épaisseur des capuchons d'extrémité ;
d'où il résulte que les pattes d'électrodes sont connectées à une source de potentiel électrique et polarisées par celle-ci de sorte qu'un déplacement axial est produit entre des faces d'extrémité opposées de l'empilement (200).

2. Empilement moteur piézo-électrique (200) selon la revendication 1, dans lequel l'empilement comprend en outre :
un premier moyen (212) pour connecter électriquement le premier agencement longitudinal de pattes (316) ; et
un second moyen (212') pour connecter électriquement le second agencement longitudinal de pattes (318) ;
pour polariser ainsi les électrodes (204) quand une source de potentiel électrique est connectée aux premier et second moyens de connexion électrique (212, 212').
